# EUROPEAN PATENT SPECIFICATION

(11) **EP 1 172 659 B1**
(45) Date of publication and mention of the grant of the patent: **15.11.2006**
(21) Application number: 01202616.7
(22) Date of filing: 06.07.2001
(51) Int. Cl.: G01R 22/00

(54) **Method and apparatus for repeating an energy consumption pulse on a modular meter**
Verfahren und Vorrichtung zur Wiederholung eines Energieverbrauchspulses in einem modularen Zähler
Méthode et dispositif de répétition d'une impulsion de consommation d'énergie dans un compteur modulaire

(30) Priority: 13.07.2000 GB 0017108
(43) Date of publication of application: 16.01.2002
(73) Proprietor: Landis+Gyr Limited, Stockport SK3 0RT (GB)
(72) Inventor: Paxton-White, Michael, Halifax, West Yorkshire HX6 4DT (GB)
(74) Representative: Humphrey-Evans, Edward John

(56) References cited:
- DE-A- 19 606 927
- GB-A- 2 273 631
- GB-A- 2 295 682

## Description

The present invention relates to modular meters. More specifically the present invention relates to a method and apparatus for repeating an energy consumption pulse on a modular electricity meter.

Modern electronic electricity meters are fitted with energy consumption indicators, which are used when calibrating and checking the accuracy of the meter. The indicators are very often fitted so that they are visible from the front of the meter. The indicator is typically a light source such as a light emitting diode (LED). Some electricity meters have the added feature of being able to obtain extra functionality through the use of add on modules. Unfortunately, these modules are constructed so that when fitted to the meter they obscure the energy consumption indicator of the meter to which they are fitted. To ensure that the consumption of energy information remains available, the modules are typically fitted with their own indicator, which repeats the operation of the energy consumption indicator on the meter. Some modules, depending on function, may additionally need to know the quantity of energy consumed and measured by the meter.

A current method for displaying an indication of consumed energy when a module is fitted to a meter is to fit a sensor within the module that will respond to the light emitted from the indicator in the meter. Circuitry within the module then repeats the indication using a separate LED fitted visible from the front of the module. As the circuitry within the meter is sensing and then repeating the indication from the meter, it is possible to also make use of the information that is gained from the sensor to obtain a value of the energy consumption measured. However, there is a cost associated with this method.

An alternative method is to repeat the energy consumption indication from the meter using a piece of optically transmissive plastic or light sensor to obtain a value of the energy consumption measured. However, there is a cost associated with this method.

An alternative method is to repeat the energy consumption indication from the meter using a piece of optically transmissive plastic or light pipe. The problem with this approach is that the design of the light pipe is complex and the cost of equipment to manufacture the part is quite high. Additionally, with this solution the module does not have access to the energy consumption indicator and so cannot measure the energy consumption.

Thus a technical problem exists in providing a cost effective means of ensuring that the consumption of energy remains indicated when a module is fitted to a meter, while at the same time allowing the module to have access to the actual energy consumption data measured by the meter. GB-A-2295682 (Siemens) discloses a modular meter: a pulsed LED acts as a repeater for pulsed signals produced by a LED 34 set in the base meter module.

It is therefore an object of the present invention to provide a method and apparatus for repeating an energy consumption pulse on a modular meter, which obviates, or at least mitigates, the problems encountered when employing the above described pulse repeating methods.

According to the present invention there is provided a metering apparatus as claimed in claim 1.

According to another aspect of the present invention there is provided a method for repeating an energy consumption pulse of a meter as claimed in claim 7.

While the principal advantages and features of the invention have been described above, a greater understanding and appreciation of the invention may be obtained by referring to the drawings and detailed description of a preferred embodiment, presented by way of example only, in which;
Figure 1 shows the meter,
Figure 2 shows the module and the meter prior to attachment, and
Figure 3 shows the module attached to the meter.

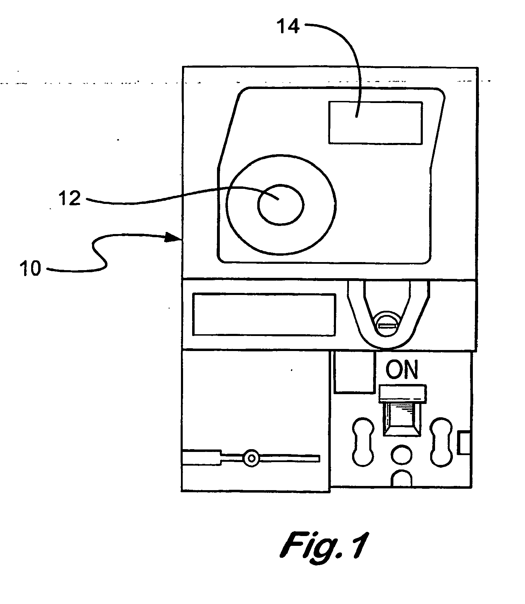

In figure 1 a meter 10 is shown comprising a communications port 12 and a light source 14. The operation of electricity meters is well known as is the use of a communications port and light sources as an energy consumption indicator. The communications port is preferably a bi-directional communications port conforming to the IEC1107 protocol, which is well known in the art.

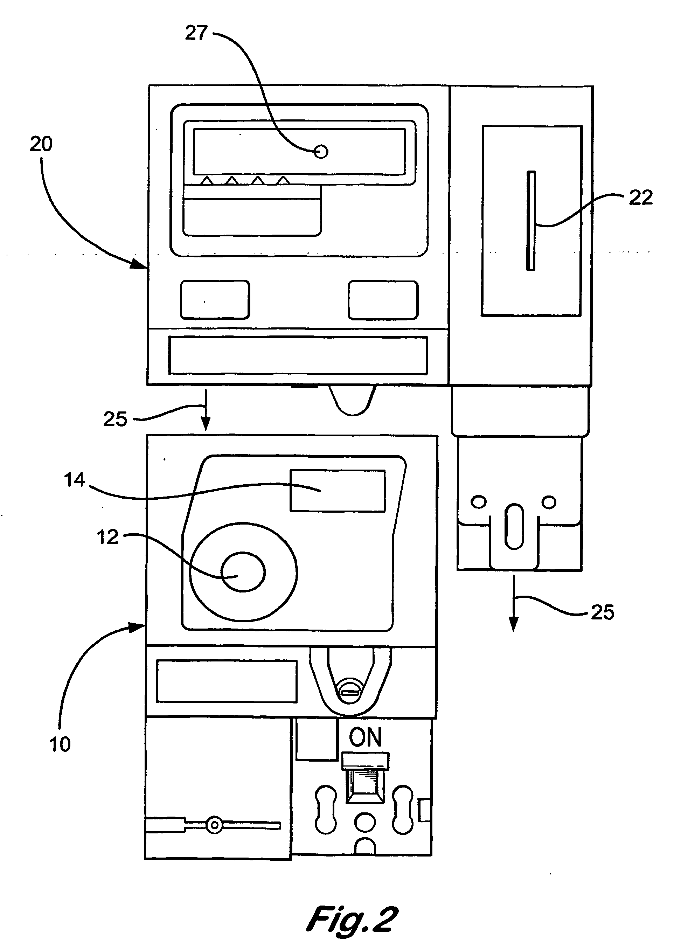

In figure 2, where parts also appearing in figure 1 bear identical references, a module 20 is shown prior to attachment to the meter 10.

The module may comprise a slot 22 for insertion of a card containing energy consumption credits. The module 20 and meter 10 are arranged such that the module can be removably attached to the meter in the direction of arrows 25. The module further comprises a receiver (not shown) arranged to receive information from the communications port 12. The module also includes a light source 27 which is arranged to emit a pulse of the dependent upon the information received by the receiver. The light source 27 is preferably a visible light emitting diode. The communications port 12 allows the module 20 and other communicating devices to read from and write to the meter values that are stored in the memory of the meter. Within the memory of the electricity meter circuitry is a value of the cumulative energy consumption over time.

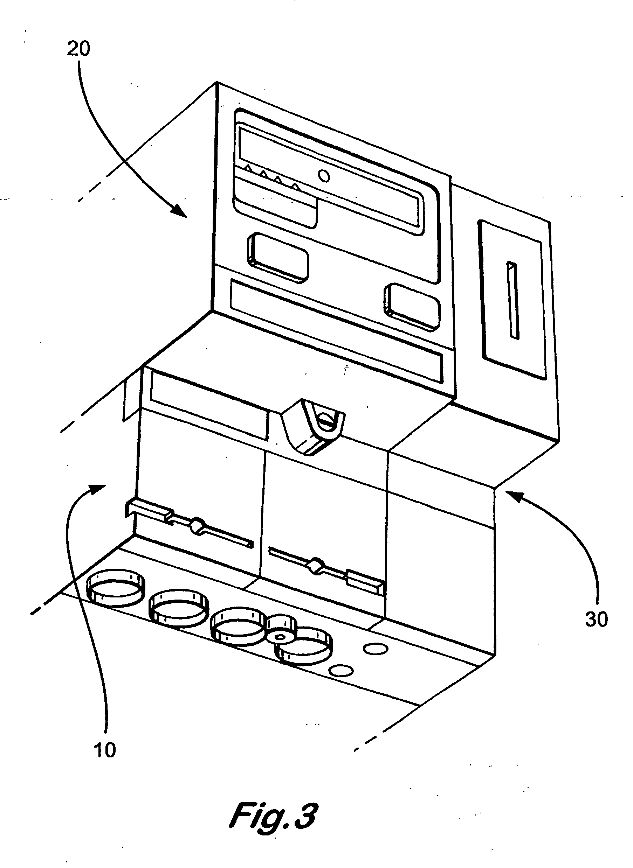

Figure 3, shows where parts also appearing in figures 1 and 2 bear identical references, shows the module 20 attached to the meter 10. The general operation of the present invention will now be described. Energy consumption data is periodically received by the receiver (not shown) via the communications port 12. This data is manipulated so as to obtain a value for the energy consumed during a predefined time interval. The module light source 27 is then caused to pulse a number of times based on the value of energy consumed during the predefined time interval. The number of pulses of the module light source indicates the amount of energy consumed during the previous predefined time interval. Thus the module effectively repeats the light pulses from the meter but delayed by the predefined time interval, the time interval being the period between receiving sets of data from the meter's memory. A specific example of the operation of the present invention will now be given. Typically, the energy consumption indicator of an electricity meter emits visible light pulses which represent and are proportional to the quantity of the consumed electricity. For example, 1000 pulses may be emitted for every 1000 Watthours of electricity consumed. Thus, in this example, 1 pulse is equivalent to an energy consumption of 1 Watthour. If the predefined time interval between receiving data is 1 second, then the module light source will emit 3 pulses of light indicating that 3 Watthours have been consumed in 1 second. If the consumption was 2.5 Watthours in 1 second then the module light source will emit 2 pulses of light per second. According to the present invention the number of light pulses emitted from the module light source is an indication of the energy consumed during the time interval immediately preceding the pulses.

Preferably the module light source is arranged to emit only whole pulses of light and any fractional part of the energy consumption is retained and added to the next time period.

It is not intended that the present invention be limited to the above embodiments and other modifications and variations are envisaged within the scope of the claims.

## Claims

1. Electricity metering apparatus comprising a base meter (10) and a meter module (20) arranged to be removably attached or linked to said base meter to provide extra functionality;
said base meter (10) having a communications port (12) disposed thereon, said communications port arranged to transmit energy consumption data;
said meter module (20) comprising a receiver arranged to receive said energy consumption data transmitted by said communications port, a light source (27) within the meter module is coupled to said receiver and arranged to emit pulses of light; **characterised in that** said receiver is operable to transmit pulses of light dependent on said energy consumption data received by said receiver at a predefined time interval and is operable to serve as an indicator of energy consumed during the time interval immediately preceding the pulses of light.

2. Apparatus as claimed in Claim 1, wherein said light source is a visible light emitting diode.

3. Apparatus as claimed in any preceding claim, where said communications port is bi-directional.

4. Apparatus as claimed in any preceding claim, wherein said module is a credit payment electricity module.

5. Apparatus as claimed in any preceding claim, wherein the module is removably linked to the meter by the communications port only.

6. A meter module using the electricity metering apparatus as defined in any one of claims 1-5.

7. A method for repeating an energy consumption pulse of an electricity metering apparatus, said method comprising the steps of:
arranging a base meter (10) to transmit energy consumption data,
disposing a meter module (20) on said base meter,
causing said meter module to receive said transmitted energy consumption data by a receiver at a predefined time interval,
causing said meter module to emit pulses of light from a light source (27), said pulses of light being transmitted in dependence upon said energy consumption data received by the receiver whereby the light source is operable to serve as an indicator of energy consumed during the time interval immediately preceding the pulses of light.

## Patentansprüche

1. Ein Stromzähler, aus einem Basiszähler (10) und einem Zählmodul (20) bestehend, wobei dieses mit besagtem Basiszähler so angeordnet ist, daß es abnehmbar angebracht oder verbunden ist, um zusätzliche Funktionalität zur Verfügung zu stellen;
besagter Basiszähler (10), welcher über einen Anschluss zur Datenübertraung (12) verfügt, wobei dieser Kommunikationsport so eingerichtet ist, dass hiermit die Energieverbrauchsdaten übertragen werden können;
besagtes Zählmodul (20), das über einen Empfänger verfügt der so eingerichtet ist, dass damit Energieverbrauchsdaten die von besagtem Kommunikationsport übertragen wurden empfangen werden, und eine im Zählmodul befindliche Lichtquelle (27) die mit dem besagten Empfänger verbunden ist und so angeordnet ist dass damit Lichtpulse ausgesendet werden; **dadurch gekennzeichnet, dass** besagter Empfänger so betriebsfähig ist, dass dieser Lichtpulse in Abhängigkeit der vom Empfänger in vordefinierten Zeitintervallen empfangenen Energieverbrauchsdaten aussendet, und so betrieben wird, dass er für das den unmittelbar vorangehenden Lichtpulsen entsprechende Zeitintervall als Energieverbrauchsanzeige dient.

2. Gerät nach Anspruch 1, wobei besagte Lichtquelle eine Leuchtdiode für sichtbares Licht ist.

3. Gerät gemäß den vorigen Ansprüchen, wobei besagter Kommunikationsport bidirektional ist.

4. Gerät gemäß den vorigen Ansprüchen, wobei besagtes Bauteil aus einem Stromzähler für Kreditkartenzahlung besteht.

5. Gerät gemäß den vorigen Ansprüchen, wobei das Bauteil nur über den Kommunikationsport abnehmbar mit dem Zähler verbunden ist.

6. Ein Zählmodul das den Stromzähler gemäß der Ansprüche 1 bis 5 verwendet.

7. Verfahren zur Wiederholung eines Energieverbrauchspulses eines Stromzählers, wobei besagtes Verfahren aus folgenden Schritten besteht:
das Einrichten eines Basiszählers (10) zur Übertragung von Energieverbrauchsdaten,
wobei besagter Basiszähler über ein Zählmodul (20) verfügt,
bewirkt, dass damit besagtes Zählmodul besagte Energieverbrauchsdaten empfängt, die von einem Empfänger zu vordefinierten Zeitintervallen übertragen wurden,
bewirkt, dass besagtes Zählmodul Lichtpulse von einer Lichtquelle (27) aussendet, wobei besagte Lichtpulse abhängig von besagten Energieverbrauchsdaten sind, die vom Emfpänger empfangen wurden, und wobei die Lichtquelle so betriebsfähig ist, dass sie für das den unmittelbar vorangehenden Lichtpulsen entsprechende Zeitintervall als Energieverbrauchsanzeige dient.

## Revendications

1. Un dispositif de mesure de l'électricité comprenant un compteur de base (10) et un module de mesure (20), disposés afin d'être ajoutés ou reliés de manière amovible au dudit compteur de base pour procurer une fonctionnalité supplémentaire ;
le dudit compteur de base (10) ayant un port de communication (12) placé au-dessus, le dudit port de communication aménagé afin de transmettre les données de consommation d'énergie;
le module de mesure dudit (20) comprenant un récepteur aménagé afin de recevoir les dudites données de consommation d'énergie transmises par le dudit port de communication, une source de lumière (27) à l'intérieur du module de mesure est connectée au dudit récepteur et elle est aménagée afin d'émettre des impulsions lumineuses; **caractérisé par** ce que le dudit récepteur est en mesure de transmettre des impulsions lumineuses en fonction des dudites données de consommation d'énergie reçues par le dudit récepteur à un intervalle de temps prédéterminé et est en mesure d'indiquer l'énergie consommée pendant l'intervalle de temps précédant immédiatement les impulsions lumineuses.

2. Un dispositif tel que celui revendiqué dans la revendication 1, où la dudite source lumineuse est une diode électroluminescente à lumière visible.

3. Un dispositif tel que celui revendiqué dans toute revendication précédente où le dudit port de communication est bi-directionnel.

4. Un dispositif tel que celui revendiqué dans toute revendication précédente où le dudit module est un module électrique de paiement par carte de crédit.

5. Un dispositif tel que celui revendiqué dans toute revendication précédente où le module est relié de manière amovible au compteur uniquement par le port de communication.

6. Un module de mesure se servant du dispositif de mesure de l'électricité, tel que définis dans l'une quelconque des revendications 1 à 5.

7. Une méthode de répétition d'une impulsion de consommation d'énergie, la dudite méthode comprenant les étapes suivantes :
aménager un compteur de base (10) de transmission des données de consommation d'énergie,
disposer un module de mesure (20) sur le dudit compteur de base,
amener le dudit module de mesure à recevoir les dudites données de consommation d'énergie par un récepteur à un intervalle de temps prédéterminé,
amener le dudit module de mesure à émettre des impulsions lumineuses depuis un source de lumière (27), les dudites impulsions lumineuses étant transmises en fonction des dudites données de consommation d'énergie captées par le récepteur, la source lumineuse étant en mesure d'indiquer l'énergie consommée pendant l'intervalle de temps précédant immédiatement les impulsions lumineuses.
